(19) Europäisches Patentamt
European Patent Office
Office européen des brevets

(11) **EP 2 815 246 B1**

(12) **EUROPÄISCHE PATENTSCHRIFT**

(45) Veröffentlichungstag und Bekanntmachung des Hinweises auf die Patenterteilung:
**19.12.2018 Patentblatt 2018/51**

(21) Anmeldenummer: **13700571.6**

(22) Anmeldetag: **18.01.2013**

(51) Int Cl.:
*G01R 31/36* (2006.01)     *G01R 31/00* (2006.01)
*H01M 10/0525* (2010.01)     *H01M 10/48* (2006.01)

(86) Internationale Anmeldenummer:
**PCT/EP2013/050875**

(87) Internationale Veröffentlichungsnummer:
**WO 2013/120650 (22.08.2013 Gazette 2013/34)**

(54) **VERFAHREN ZUM BESTIMMEN EINES STROMS, BATTERIEMANAGEMENTEINHEIT, BATTERIE UND KRAFTFAHRZEUG**

METHOD FOR DETERMINING A CURRENT, BATTERY MANAGEMENT UNIT, BATTERY AND MOTOR VEHICLE

PROCÉDÉ DE DÉTERMINATION D'UN COURANT, UNITÉ DE GESTION DE BATTERIE, BATTERIE ET VÉHICULE AUTOMOBILE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **13.02.2012 DE 102012202077**

(43) Veröffentlichungstag der Anmeldung:
**24.12.2014 Patentblatt 2014/52**

(73) Patentinhaber:
• **Robert Bosch GmbH**
**70442 Stuttgart (DE)**
• **Samsung SDI Co., Ltd.**
**Yongin-si**
**Gyeonggi-do 446-577 (KR)**

(72) Erfinder:
• **BOEHM, Andre**
**70806 Kornwestheim (DE)**
• **WICKERT, Stefan**
**73095 Albershausen (DE)**

• **HEUBNER, Anne**
**70469 Stuttgart (DE)**

(74) Vertreter: **Bee, Joachim**
**Robert Bosch GmbH**
**Zentralabteilung Patente**
**Postfach 30 02 20**
**70442 Stuttgart (DE)**

(56) Entgegenhaltungen:
**WO-A1-2006/054066     DE-A1-102009 049 589**
**US-A1- 2005 110 498**

• **MARK W. VERBRUGGE AND ROBERT S. CONELL: "Electrochemical and Thermal Characterization of Battery Modules Commensurate with Electric Vehicle Integration", JOURNAL OF THE ELECTROTECHNICAL SOCIETY, Bd. 149, Nr. 1, 31. Dezember 2001 (2001-12-31), Seiten A45-A53, XP002695813, USA**

**Beschreibung**

Die vorliegende Erfindung betrifft ein Verfahren zum Bestimmen eines Stroms, insbesondere eines Kurzschlussstroms, einer Batterie über einen bestimmten Prädiktionszeitraum. Außerdem betrifft die Erfindung eine Batteriemanagementeinheit, die dazu ausgebildet ist, das Verfahren auszuführen; eine Batterie mit der Batteriemanagementeinheit; und ein Kraftfahrzeug mit der Batterie oder mit der Batteriemanagementeinheit.

Stand der Technik

Bekannte Stromsensoren für Lithium-Ionen-Batterie- oder auch Brennstoff-Zell-Systeme verfügen über einen begrenzten Messbereich und eine begrenzte Auflösung. Je genauer solche Stromsensoren die Ströme auflösen, desto kleiner ist in der Regel ihr Messbereich. Dies verursacht Messunsicherheiten über die Höhe der tatsächlich geflossenen Ströme, beispielsweise sind Lithium-Ionen-Batteriesysteme mit sicherheitsrelevanten Bauelementen wie Schützen und Sicherungen ausgestattet, deren Lebensdauer stark von der Höhe des Stromes abhängt, mit dem sie belastet werden.

Die in einem Fehlerfall in einem Batteriesystem auftretenden Ströme sind jedoch häufig so hoch, dass sie herkömmliche Stromsensoren nicht mehr zuverlässig bestimmen können. Zur Gewährleistung der vollen Funktionalität sicherheitsrelevanter Bauelemente wird der hohe Strom als maximal schädigend angenommen. Die Bauelemente werden daher unter Umständen bereits vor dem Erreichen ihres tatsächlichen Lebensendes ausgetauscht. Zusätzlich werden solche sicherheitsrelevanten Bauelemente herstellungsseitig ohne genaue Kenntnis der im Fehlerfall auftretenden Ströme häufig überdimensioniert.

Aus der vorangemeldeten und nachveröffentlichten DE 10 2011 007 884.3 ist ein Verfahren zur Bestimmung eines über einen Prädiktionszeitraum maximal verfügbaren Konstantstroms einer Batterie bekannt. Dieses Verfahren ermittelt zunächst einen Batteriezustand und bestimmt anschließend die Lösung einer Differentialgleichung, die die zeitliche Entwicklung des Batteriezustands im Verlauf des Prädiktionszeitraums mithilfe eines Ersatzschaltbildmodells beschreibt. Beim Bestimmen der Lösung der Differentialgleichung wird vorausgesetzt, dass der von der Batterie gelieferte Strom über den Prädiktionszeitraum hinweg konstant ist. In die Lösung der Differentialgleichung wird eine einzuhaltende Spannungsgrenze eingesetzt und so der maximal verfügbare Konstantstrom bestimmt.

Die US 2005/0110498 A1 offenbart ein Verfahren, mit welchem die Entwicklung der maximalen Lade- beziehungsweise Entladefähigkeit einer Batterie über einen Prädiktionszeitraum Δt geschätzt werden kann. Dazu wird der maximale Ladebeziehungsweise Entladestrom berechnet, wobei auf eine Kombination von festgellten Primärgrenzwerten zurückgegriffen wird.

Offenbarung der Erfindung

Erfindungsgemäß wird ein Verfahren zum Bestimmen eines Stroms, insbesondere eines Kurzschlussstroms, einer Batterie über einen bestimmten Prädiktionszeitraum bereitgestellt. Das erfindungsgemäße Verfahren umfasst folgende Schritte: Messen einer Spannung der Batterie, Auslesen eines Batteriezustands und Bestimmen der Lösung einer Differentialgleichung, die die zeitliche Entwicklung des Stroms im Verlauf des Prädiktionszeitraums mithilfe eines Ersatzschaltbildmodells beschreibt. Die Differentialgleichung umfasst den Batteriezustand und die gemessene Spannung.

Die Batteriemanagementeinheit ist dazu ausgebildet, das erfindungsgemäße Verfahren auszuführen. Die Batterie umfasst die Batteriemanagementeinheit. Das Kraftfahrzeug umfasst die Batterie, die mit einem Antriebssystem des Kraftfahrzeugs verbunden ist, oder die Batteriemanagementeinheit.

Vorteile der Erfindung

In einem Fehlerfall in einer Batterie auftretende hohe Ströme können durch bekannte Stromsensoren nur ungenau oder überhaupt nicht bestimmt werden. Das erfindungsgemäße Verfahren ermöglicht eine Abschätzung von hohen Strömen, z. B. Kurzschlussströmen, anhand einer Spannungsantwort der Batterie, insbesondere der einzelnen Batteriezellen der Batterie. In einer Batterie eingesetzte Sicherheitsbauelemente, beispielsweise Schütze oder Sicherungen, können durch die Bestimmung des Stroms genauer ausgelegt werden, eine Überdimensionierung der Bauelemente wie im Stand der Technik üblich kann verringert oder vermieden werden. In einem möglichen Fehlerfall wurden bisher Sicherheitsbauteile in der Regel vorsichtshalber ausgetauscht, unter Umständen jedoch ohne ihr tatsächliches Lebensende bereits erreicht zu haben. Das erfindungsgemäße Verfahren kann daher unnötige Reparaturen und Bauelementekosten einsparen. Das Verfahren kann ferner zur Bestimmung von Bauteilbelastungen verwendet werden.

Das erfindungsgemäße Verfahren ermöglicht außerdem eine genauere Klassifizierung der Lebensdauer der Sicherheitsbauteile. Als weiterer Vorteil kann das Verfahren zur Plausibilisierung eines Batteriestromsensors dienen und insbesondere Stromabsolutwerte oder dynamische Effekte bestimmen. Dadurch kann der Einsatz teurer zusätzlicher Stromsensoren eingespart werden. Werden mehrere Stromsensoren in einer Batterie verwendet, ist durch das Verfahren bei Ausfall eines der Stromsensoren feststellbar, welcher der mehreren

Stromsensoren defekt ist.

Außerdem kann der durch das Verfahren bestimmte Strom zur Kalibrierung von Stromsensoren dienen, insbesondere zur Kompensation von Offsets und Drifteffekten. Ferner kann das Verfahren zur Verarbeitung von Sensorrauschen dienen. Ändert sich beispielsweise die Batteriespannung nicht, ein Stromsensor ermittelt jedoch Stromänderungen gegenüber dem aus dem Verfahren bestimmten Strom, so liegt in der Regel Rauschen vor. Das Verfahren ist also auch zum Filtern von Rauschen des Stromsensors einsetzbar. Das Verfahren kann ferner zur Definition von Schwellwertüberschreitungen anhand korrigierter Stromwerte eingesetzt werden.

Gemäß einer Ausführungsform der Erfindung kann der Batteriezustand mehrere Batterieparameter des Ersatzschaltbildmodells umfassen, wobei die Batterieparameter während der Bestimmung des Stroms als konstant angenommen werden.

Gemäß einer weiteren Ausführungsform kann das erfindungsgemäße Verfahren ferner den Schritt umfassen: erneutes Bestimmen des Stroms, wenn ein Strommesswert innerhalb des Messbereichs eines Stromsensors der Batterie messbar ist.

Gemäß einer weiteren Ausführungsform kann das Verfahren ferner den Schritt umfassen: Bestimmen des Stroms durch Einsetzen des Strommesswerts zu Beginn des Prädiktionszeitraums in die allgemeine Lösung der Differentialgleichung.

Gemäß einer weiteren Ausführungsform kann das Verfahren ferner den Schritt umfassen: Messen der Temperatur der Batterie und Bestimmen der Lösung der Differentialgleichung, ferner die gemessene Temperatur umfassend. Insbesondere umfasst die Differentialgleichung bzw. die Lösung der Differentialgleichung die gemessene Spannung und/oder die gemessene Temperatur.

Gemäß einer weiteren Ausführungsform kann das Ersatzschaltbildmodell eine Reihenschaltung eines ersten Widerstands und eines weiteren Glieds umfassen, wobei das weitere Glied durch eine Parallelschaltung eines zweiten Widerstands und eines Kondensators gebildet sein kann. Ferner können andere Ersatzschaltbildmodelle verwendet werden.

Vorzugsweise bilden die Werte des ersten Widerstands, des zweiten Widerstands und des Kondensators Batterieparameter.

Die Batteriemanagementeinheit kann gemäß einer Ausführungsform Mittel zum Ermitteln und Bereitstellen des Batteriezustands und eine Steuereinheit umfassen. Die Steuereinheit ist vorzugsweise dazu ausgebildet, die Lösung der Differentialgleichung zu bestimmen.

Die Batterie kann gemäß einer Ausführungsform wenigstens eine Lithium-Ionen-Batteriezelle umfassen. Das erfindungsgemäße Verfahren kann insbesondere zum Bestimmen eines Stroms der Lithium-Ionen-Batteriezelle verwendet werden.

Zeichnungen

Ausführungsbeispiele der Erfindung werden anhand der Zeichnung und der nachfolgenden Beschreibung näher erläutert. Es zeigt:

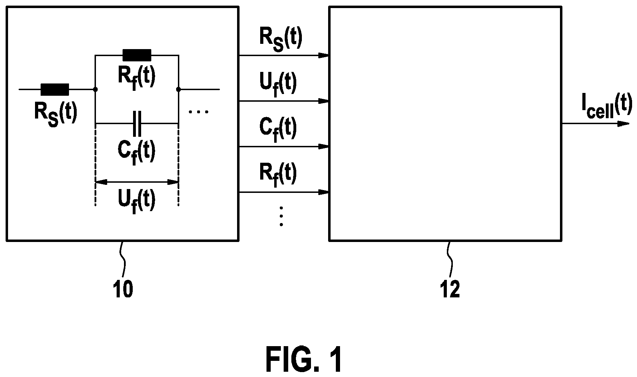

Figur 1 ein Ersatzschaltbild zur Verwendung in einem Ausführungsbeispiel des erfindungsgemäßen Verfahrens.

Ausführungsformen der Erfindung

Das erfindungsgemäße Verfahren beruht darauf, einen Strom, insbesondere einen Kurzschlussstrom, einer Batterie oder Batteriezelle mithilfe eines Ersatzschaltbildmodells zu bestimmen bzw. vorherzusagen. In der Figur 1 ist ein Beispiel eines hierfür geeigneten Ersatzschaltbildmodells gezeigt. Das Ersatzschaltbildmodell wird in einem Batteriezustandbestimmungsmodul 10 abgebildet und aktualisiert. Es umfasst einen ohmschen Widerstand $R_S$ und ein weiteres Glied, das zum Widerstand $R_S$ in Reihe geschaltet ist, wobei das weitere Glied aus einem ohmschen Widerstand $R_f$ und einer Kapazität $C_f$ besteht, die parallel geschaltet sind und ein RC-Glied bilden. Die Werte der Bauelemente $R_S$, $R_f$ und $C_f$ bilden Batterieparameter des Ersatzschaltbildmodells. Das Abbilden des Ersatzschaltbildmodells umfasst dabei beispielsweise ein Speichern der Batterieparameter in einem Datenspeicher des Batteriezustandbestimmungsmoduls 10. Wahlweise kann auch ein Ersatzschaltbildmodell mit beliebiger Anzahl beliebig parametrisierter ohmscher Widerstände und RC-Gliedern verwendet werden.

Zur Bestimmung bzw. Vorhersage der zeitlichen Entwicklung des Stroms wird mithilfe des Ersatzschaltbildmodells eine Differentialgleichung aufgestellt. Die Batterie- bzw. Batteriezellenspannung $U_{cell}$ ist dabei zu jedem Zeitpunkt als

$$U_{cell}(t) = U_{OCV}(t) + U_S(t) + U_f(t) \qquad \text{Gl. (1)}$$

gegeben. Dabei bezeichnet $U_{OCV}$ eine Leerlaufspannung der Batterie. Die Spannung $U_S$ am Widerstand $R_S$ errechnet sich aus

$$U_S = R_S\big(SOC(t), T(t)\big) \cdot I_{cell}(t) \qquad \text{Gl. (2)}$$

Der Widerstand $R_S$ ist dabei abhängig von dem Ladezustand (engl. state of charge) $SOC(t)$ der Batterie sowie der Temperatur $T(t)$ der Batterie.

Die in Gl. (1) letztgenannte Spannung $U_f$ liegt über dem RC-Glied an und ist durch die Lösung folgender Differentialgleichung bestimmt

$$C_f\big(SOC(t), T(t)\big)\frac{d}{dt}U_f(t) + \frac{U_f(t)}{R_f\big(SOC(t), T(t)\big)} = I_{cell}(t) \qquad \text{Gl. (3)}$$

für $t > t_0$ und einen Anfangswert $U_f^0 = U_f(t_0)$. Die Änderung des Ladezustands und der Temperatur der Batterie sind während der Berechnungszeit vernachlässigbar gering. Daher werden $R_S = const.$, $R_f = const.$ und $C_f = const.$, das heißt jeweils als während des Prädiktionszeitrams konstant angenommen. Die aktuelle Spannung $U_f(t)$ sowie die aktuellen Werte, das heißt Batterieparameter, der Bauelemente $R_S$, $R_f$ und $C_f$ sind durch eine Modellberechnung im Batteriezustandbestimmungsmodul 10 gegeben.

Die zeitabhängige Leerlaufspannung $U_{OCV}(t)$ aus Gleichung Gl. 1 kann näherungsweise berechnet aus einer Leerlaufspannung zu Beginn eines Prädiktionszeitraums plus der Änderung der Leerlaufspannung während des Prädiktionszeitraums berechnet werden.

$$U_{OCV}(t) = U_{OCV}(t_0) + \Delta U_{OCV} = U_{OCV}(t_0) + \Delta SOC(t)\frac{\partial U_{OCV}}{\partial SOC} \qquad \text{Gl. (4)}$$

Die in Gl. (4) enthaltene Ladezustandsdifferenz berechnet sich wie folgt

$$\Delta SOC(t) = \int I_{cell}\, dt \cdot \frac{100}{3600 \cdot chCap} \qquad \text{Gl. (5)}$$

Dabei bezeichnet $chCap$ die Batteriegesamtkapazität. Des Weiteren umfasst Gl. (4) einen vom Ladungszustand abhängigen Steigungsterm $\frac{\partial U_{OCV}}{\partial SOC}(SOC)$. Der Steigungsterm ist die partielle Ableitung der Leerlaufspannung nach dem Ladezustand und kann einmal berechnet und als Kennfeld in einer Batteriemanagementeinheit abgespeichert oder bei Bedarf aus einem bekannten Kennfeld $U_{OCV}(SOC)$ berechnet werden.

In einer vereinfachten Schreibweise wird ferner $r_f = C_f R_f$ definiert. Stellt man Gl. (3) um und setzt die vereinfachte Schreibweise ein, erhält man eine umgestellte Differentialgleichung Gl. (6).

$$\dot{U}_f(t) = -\frac{1}{\tau_f}U_f(t) + \frac{1}{C_f}I_{cell}(t) \qquad \text{Gl. (6)}$$

$$U_f\left(t_0\right)=U_f^0$$

$\forall t > t_0$ und

In einem nächsten Schritt kann Gl. (6) mittels Gl. (1) und (2) zusammengefasst und umgestellt werden zu Gl. (2').

$$U_f = U_{cell} - U_{OCV} - R_S I_{cell} \qquad \text{Gl. (2')}$$

Gleichung Gl. (4) und Gl. (5) werden zusammengefasst und umgestellt zu Gl. (4'),

$$\dot{U}_{OCV} = \frac{\partial U_{OCV}}{\partial SOC} \cdot \frac{100}{3600 \cdot chCap} \cdot I_{cell} \qquad \text{Gl. (4')}$$

wobei eine weitere vereinfachte Schreibweise eingeführt wird

$$\lambda = \frac{\partial U_{OCV}}{\partial SOC} \cdot \frac{100}{3600 \cdot chCap}$$

Setzt man die Beziehung für $U_f$ Gl. (2') unter Berücksichtigung von Gl. (4') beidseitig in die Differentialgleichung Gl. (6) ein, erhält man Gl. (7)

$$\frac{1}{\tau_f}U_{cell} + \dot{U}_{cell} = R_S \cdot \dot{I}_{cell} + \left(\lambda + \frac{R_f + R_S}{\tau_f}\right) \cdot I_{cell} + \frac{\lambda}{\tau_f}\int I_{cell}\, dt \qquad \text{Gl. (7)}$$

Um aus Gl. (7) eine Differentialgleichung bezüglich des Stroms $I_{cell}$ zu erhalten, wird Gl. (7) nach der Zeit abgeleitet zu Gl. (8)

$$R_S \cdot \ddot{I}_{cell} + \left(\lambda + \frac{R_f + R_S}{\tau_f}\right) \cdot \dot{I}_{cell} + \frac{\lambda}{\tau_f} \cdot I_{cell} = \frac{1}{\tau_f}\dot{U}_{cell} + \ddot{U}_{cell} \qquad \text{Gl. (8)}$$

Der Spannungsmesswert $U_{cell}(t)$ und dessen Ableitungen $\dot{U}_{cell}(t)$ und $\ddot{U}_{cell}(t)$ sind durch Messungen gegeben. Die resultierende Differentialgleichung Gl. (8) ist linear, inhomogen und besitzt konstante Koeffizienten.

Lösung der Differentialgleichung

Zur Lösung der Differentialgleichung Gl. (8) wird zunächst ein Fundamentalsystem der homogenen Form anhand des charakteristischen Polynoms gebildet.

$$\left\{\exp\left(-m_1 t\right), \exp\left(-m_2 t\right)\right\} \qquad \text{Gl. (9)}$$

Die Koeffizienten des charakteristischen Polynoms berechnen sich zu

$$m_1 = \frac{\lambda + \dfrac{R_s + R_f}{\tau_f}}{2R_s} - \sqrt{\frac{\left(\lambda + \dfrac{R_s + R_f}{\tau_f}\right)^2}{4R_s^2} - \frac{\lambda}{R_s \tau_f}}$$

$$m_2 = \frac{\lambda + \dfrac{R_s + R_f}{\tau_f}}{2R_s} + \sqrt{\frac{\left(\lambda + \dfrac{R_s + R_f}{\tau_f}\right)^2}{4R_s^2} - \frac{\lambda}{R_s \tau_f}} \qquad \text{Gl. (10, 11)}$$

Mittels des Lösungsverfahrens Variation der Konstanten bestimmt eine Steuereinheit 12 zunächst eine spezielle Lösung Gl. (12) der inhomogenen Form der Differentialgleichung Gl. (8).

$$I_s(t) = c_1(t)\exp(-m_1 t) + c_2(t)\exp(-m_2 t) \qquad \text{Gl. (12)}$$

wobei ein lineares Gleichungssystem

$$\dot{c}_1(t)\exp(-m_1 t) + \dot{c}_2(t)\exp(-m_2 t) = 0$$

$$-m_1\dot{c}_1(t)\exp(-m_1 t) - m_2\dot{c}_2(t)\exp(-m_2 t) = \psi \qquad \text{Gl. (13, 14)}$$

mit der verkürzten Schreibweise

$$\Psi = \frac{\dfrac{1}{\tau_f}\dot{U}_{cell} + \ddot{U}_{cell}}{R_s} \qquad \text{Gl. (15)}$$

für die Konstanten ergibt

$$\dot{c}_1(t) = \frac{\Psi \exp(m_1 t)}{m_2 - m_1}$$

$$\dot{c}_2(t) = \frac{\Psi \exp(m_2 t)}{m_2 - m_1} \qquad \text{Gl. (16, 17)}$$

und damit unter Annahme eines zeitkonstanten $\Psi$

$$I_s = \frac{\Psi \exp(m_1 t)}{m_1(m_2 - m_1)}\exp(-m_1 t) - \frac{\Psi \exp(m_2 t)}{m_2(m_2 - m_1)}\exp(-m_2 t) = \frac{\Psi}{m_1 m_2} \qquad \text{Gl. (18)}$$

Würde man $\Psi$ als nicht zeitkonstant annehmen, wäre

$$I_S = \frac{\Psi \exp(m_1 t)}{m_1(m_2 - m_1)}\exp(-m_1 t) - \frac{\Psi \exp(m_2 t)}{m_2(m_2 - m_1)}\exp(-m_2 t) = \frac{\Psi}{m_1 m_2}$$ Gl. (18')

Die Bestimmung der Gesamtlösung der Differentialgleichung Gl. (8) erfolgt in der Steuereinheit 12 anhand vorbekannter Anfangsbedingungen. Die allgemeine Lösung der inhomogenen Form der Differentialgleichung Gl. (8) dazu lautet

$$I_{cell}(t) = \mu_1 \exp(-m_1 t) + \mu_2 \exp(-m_2 t) + I_S$$ Gl. 19

Die Parameter $\mu_1$, $\mu_2$ errechnen sich mithilfe zweier Anfangsbedingungen, z. B.

$$I_{cell}(0) = I_0 \text{ und } \dot{I}_{cell}(0) = \dot{I}_0$$

Bei konstantem $\Psi$, vgl. Gl. 18 können die Parameter $\mu_1$, $\mu_2$ berechnet werden zu

$$\mu_1 = \frac{m_2 I_0 + \dot{I}_0}{m_2 - m_1}$$

$$\mu_1 = \frac{m_1 I_0 + \dot{I}_0}{m_2 - m_1}$$ Gl. (20, 21)

Damit ist die Lösung der Differentialgleichung Gl. (8)

$$I_{cell}(t) = \frac{e^{-m_1 t}}{m_2 - m_1}\left(m_2 I_0 + \dot{I}_0 + \int_0^t \Psi(\tau)e^{m_1 \tau}\, d\tau\right) - \frac{e^{-m_2 t}}{m_2 - m_1}\left(m_1 I_0 + \dot{I}_0 + \int_0^t \Psi(\tau)e^{m_2 \tau}\, d\tau\right)$$

Gl. (22)

Sobald ein verlässlicher Strommesswert $I_0$ bzw. $\dot{I}_0$ vorliegt, das heißt ein Strommesswert innerhalb eines beschränkten Messbereichs eines herkömmlichen Stromsensors, kann die Steuereinheit 12 mittels der Lösung Gl. (22) der Differentialgleichung den Strom $I_{cell}(t)$ über einen bestimmten Prädiktionszeitraum t bestimmen. Den dazu nötigen Batteriezustand liefert das Batteriezustandbestimmungsmodul 10. Eine Batteriemanagementeinheit umfasst das Batteriezustandbestimmungsmodul 10 und die Steuereinheit 12.

Die ebenfalls die Berechnung einfließende Batteriespannung $U_{cell}(t)$ und deren Ableitungen können gemessen werden. Die Bestimmung von $I_{cell}(t)$ wird bei Vorliegen weiterer verlässlicher Strommesswerte wiederholt, um beispielsweise plötzlich stark ansteigende Ströme, z. B. Kurzschlussströme, in einer Batterie oder einer Batteriezelle bestimmen zu können.

**Patentansprüche**

1. Verfahren zum Bestimmen eines Stroms, insbesondere eines Kurzschlussstroms, einer Batterie über einen bestimmten Prädiktionszeitraum, **dadurch gekennzeichnet, dass** das Verfahren folgende Schritte umfasst:

   Messen einer Spannung der Batterie,
   Auslesen eines Batteriezustands und
   Bestimmen der Lösung einer Differentialgleichung, die die zeitliche Entwicklung des Stroms im Verlauf des Prädiktionszeitraums mithilfe eines Ersatzschaltbildmodells beschreibt und den Batteriezustand umfasst, **dadurch gekennzeichnet, dass**

die Differentialgleichung ferner die gemessene Spannung umfasst.

2. Verfahren nach Anspruch 1, bei welchem der Batteriezustand mehrere Batterieparameter des Ersatzschaltbildmodells umfasst, wobei die Batterieparameter während der Bestimmung des Stroms als konstant angenommen werden.

3. Verfahren nach einem der Ansprüche 1 oder 2, wobei das Verfahren ferner den Schritt umfasst:

erneutes Bestimmen des Stroms, wenn ein Strommesswert innerhalb des Messbereichs eines Stromsensors der Batterie messbar ist.

4. Verfahren nach Anspruch 3, wobei das Verfahren ferner den Schritt umfasst:

Bestimmen des Stroms durch Einsetzen des Strommesswerts zu Beginn des Prädiktionszeitraums in die allgemeine Lösung der Differentialgleichung.

5. Verfahren nach einem der vorhergehenden Ansprüche, wobei das Verfahren ferner den Schritt umfasst:

Messen der Temperatur der Batterie und
Bestimmen der Lösung der Differentialgleichung, ferner die gemessene Temperatur umfassend.

6. Verfahren nach einem der vorhergehenden Ansprüche, wobei das Ersatzschaltbildmodell eine Reihenschaltung eines ersten Widerstands ($R_S$) und eines weiteren Glieds umfasst, wobei das weitere Glied durch eine Parallelschaltung eines zweiten Widerstands ($R_f$) und eines Kondensators ($C_f$) gebildet ist.

7. Verfahren nach einem der vorhergehenden Ansprüche, wobei die Werte des ersten Widerstands ($R_S$), des zweiten Widerstands ($R_f$) und des Kondensators ($C_f$) Batterieparameter bilden.

8. Batteriemanagementeinheit, die dazu ausgebildet ist, das Verfahren gemäß einem der vorhergehenden Ansprüche auszuführen.

9. Batteriemanagementeinheit nach Anspruch 8, umfassend ein Batteriezustandbestimmungsmodul (10) zum Ermitteln und Bereitstellen des Batteriezustands und
eine Steuereinheit (12), die dazu ausgebildet ist, die Lösung der Differentialgleichung zu bestimmen.

10. Batterie mit einer Batteriemanagementeinheit nach einem der Ansprüche 8 oder 9.

11. Batterie nach Anspruch 10, wobei die Batterie wenigstens eine Lithium-Ionen-Batteriezelle umfasst.

12. Kraftfahrzeug, mit einer Batterie nach einem der Ansprüche 10 oder 11, wobei die Batterie mit einem Antriebssystem des Kraftfahrzeugs verbunden ist, oder mit einer Batteriemanagementeinheit nach einem der Ansprüche 8 oder 9.

**Claims**

1. Method for determining a current, in particular a short circuit current, of a battery over a particular prediction period, **characterized in that** the method comprises the following steps of:

measuring a voltage of the battery,
reading a battery condition, and
determining the solution to a differential equation which describes the temporal development of the current over the course of the prediction period with the aid of an equivalent circuit diagram model and comprises the battery condition,
**characterized in that**
the differential equation also comprises the measured voltage.

2. Method according to Claim 1, in which the battery condition comprises a plurality of battery parameters of the equivalent circuit diagram model, wherein the battery parameters are assumed to be constant while determining the current.

3.  Method according to either of Claims 1 and 2, wherein the method also comprises the step of:

    determining the current again if it is possible to measure a current measured value within the measurement range of a current sensor of the battery.

4.  Method according to Claim 3, wherein the method also comprises the step of:

    determining the current by inserting the current measured value at the start of the prediction period into the general solution to the differential equation.

5.  Method according to one of the preceding claims, wherein the method also comprises the step of:

    measuring the temperature of the battery, and
    determining the solution to the differential equation, also comprising the measured temperature.

6.  Method according to one of the preceding claims, wherein the equivalent circuit diagram model comprises a series circuit comprising a first resistor ($R_S$) and a further element, wherein the further element is formed by a parallel circuit comprising a second resistor ($R_f$) and a capacitor ($C_f$) .

7.  Method according to one of the preceding claims, wherein the values of the first resistor ($R_S$), the second resistor ($R_f$) and the capacitor ($C_f$) form battery parameters.

8.  Battery management unit which is designed to carry out the method according to one of the preceding claims.

9.  Battery management unit according to Claim 8, comprising
    a battery condition determination module (10) for determining and providing the battery condition, and a control unit (12) which is designed to determine the solution to the differential equation.

10. Battery having a battery management unit according to either of Claims 8 and 9.

11. Battery according to Claim 10, wherein the battery comprises at least one lithium ion battery cell.

12. Motor vehicle having a battery according to either of Claims 10 and 11, wherein the battery is connected to a drive system of the motor vehicle, or having a battery management unit according to either of Claims 8 and 9.


**Revendications**

1.  Procédé de détermination d'un courant, en particulier d'un courant de court-circuit, d'une batterie au cours d'une période de prédiction déterminée, **caractérisé en ce que** le procédé comprend les étapes suivantes :

    mesure d'une tension de la batterie,
    lecture d'un état de la batterie et
    détermination de la solution d'une équation différentielle qui décrit l'évolution temporelle du courant au cours de la période de prédiction au moyen d'un modèle de circuit équivalent et qui comprend l'état de la batterie, **caractérisé en ce que** l'équation différentielle comprend en outre la tension mesurée.

2.  Procédé selon la revendication 1, dans lequel l'état de la batterie comprend une pluralité de paramètres de batterie du modèle de circuit équivalent, dans lequel les paramètres de batterie sont supposés être constants pendant la détermination du courant.

3.  Procédé selon l'une des revendications 1 ou 2, dans lequel le procédé comprend en outre l'étape suivante :

    détermination à nouveau du courant lorsqu'une valeur de courant peut être mesurée dans la plage de mesure d'un capteur de courant de la batterie.

4.  Procédé selon la revendication 3, dans lequel le procédé comprend en outre l'étape suivante :

détermination du courant en introduisant la valeur de courant mesurée au début de la période de prédiction dans la solution générale de l'équation différentielle.

5. Procédé selon l'une des revendications précédentes, dans lequel le procédé comprend en outre l'étape suivante :

mesure de la température de la batterie et
détermination de la solution de l'équation différentielle, qui comprend en outre la température mesurée.

6. Procédé selon l'une des revendications précédentes, dans lequel le modèle de circuit équivalent comprend un circuit série d'une première résistance (Rs) et d'un autre élément, dans lequel l'autre élément est formé par un circuit parallèle d'une seconde résistance ($R_f$) et d'un condensateur ($C_f$).

7. Procédé selon l'une des revendications précédentes, dans lequel les valeurs de la première résistance ($R_S$), de la seconde résistance ($R_f$) et du condensateur ($C_f$) constituent des paramètres de batterie.

8. Unité de gestion de batterie conçue pour mettre en oeuvre le procédé selon l'une des revendications précédentes.

9. Unité de gestion de batterie selon la revendication 8, comprenant
un module de détermination de l'état de batterie (10) permettant de déterminer et de fournir l'état de batterie et
une unité de commande (12) qui est conçue pour déterminer la solution de l'équation différentielle.

10. Batterie comportant une unité de gestion de batterie selon l'une des revendications 8 ou 9.

11. Batterie selon la revendication 10, dans laquelle la batterie comprend au moins un élément de batterie au lithium-ion.

12. Véhicule automobile, comportant une batterie selon l'une des revendications 10 ou 11, dans lequel la batterie est reliée à un système de propulsion du véhicule automobile, ou à une unité de gestion de batterie selon l'une des revendications 8 ou 9.

**FIG. 1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102011007884
- US 20050110498 A1